(19)

Europäisches
Patentamt

European
Patent Office

Office européen
des brevets

(11) **EP 4 322 234 A1**

(12) **EUROPEAN PATENT APPLICATION**
published in accordance with Art. 153(4) EPC

(43) Date of publication:
**14.02.2024 Bulletin 2024/07**

(21) Application number: **21936141.7**

(22) Date of filing: **30.04.2021**

(51) International Patent Classification (IPC):
**H01L 51/42** (2006.01)     **H01L 51/44** (2006.01)
**H01L 51/00** (2006.01)

(52) Cooperative Patent Classification (CPC):
**H10K 30/00; H10K 30/80; H10K 99/00;**
Y02E 10/549

(86) International application number:
**PCT/KR2021/005533**

(87) International publication number:
**WO 2022/215803 (13.10.2022 Gazette 2022/41)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.04.2021  KR 20210045905**

(71) Applicant: **University Of Seoul Industry
Cooperation Foundation
Dongdaemun-gu, Seoul 02504 (KR)**

(72) Inventor: **KIM, Hyeok
Seoul 02553 (KR)**

(74) Representative: **Rückerl, Florian
Dehmel & Bettenhausen
Patentanwälte PartmbB
Herzogspitalstraße 11
80331 München (DE)**

(54) **INDOOR ORGANIC SOLAR CELL USING PSS-DOPED POLYANILINE AS HOLE TRANSPORT LAYER**

(57)     PSS-doped polyaniline (PANI), which is inexpensive, less acidic, and stable in water, is used as a hole transport material (HTM) of an organic photovoltaic (OPV) cell for efficiently collecting energy from indoor lighting. Therefore, the organic photovoltaic cell exhibits a transmittance of 90% or more. Also, a solar cell according to the present invention has improved environmental stability.

[FIG, 1]

**EP 4 322 234 A1**

**Description**

[Technical Field]

The present invention relates to an indoor organic photovoltaic cell. More particularly, the present invention relates to an indoor organic photovoltaic cell using poly(4-styrenesulfonic acid) (PSS)-doped polyaniline (PANI) as a hole transport layer.

[Background Art]

There is an increasing demand for low-dimensional, micro-power and wireless indoor electronic devices. Organic photovoltaic (OPV) cells are used to supply power to these devices. OPV cells exhibit excellent spectral matching and mechanical flexibility, and may efficiently collect energy from artificial indoor lighting. The hole transport layer (HTL) is an important component of OPV cells. Generally, a poly(3,4-ethylene dioxythiophene):poly (4-styrenesulfonic acid) (PEDPT:PSS)-based HTL, which is stable in water and able to be processed at a low temperature, is used in indoor OPV cells. However, because PEDOT:PSS is strongly acidic, highly hydrophilic, and expensive, there is a need to develop alternative hole transport materials (HTMs) for indoor OPV cells that are inexpensive, weakly acidic, and less sensitive to humidity.

[Related-Art Documents]

[Non-Patent Documents]

Mathews et al., Technology and market: perspective for indoor photovoltaic cells, Joule 3 (2019) 1415-1426.
Abdulrazzaq et al., Comparative aging study of organic solar cells utilizing polyaniline and PEDOT: PSS as hole transport layers, ACS Appl. Mater. Interfaces 7 (2015) 27667-27675.

[Disclosure]

[Technical Problem]

The present invention is directed to providing an inexpensive hole transport material (HTM) for indoor OPV cells.
Also, the present invention is directed to providing an alternative hole transport material that has improved stability because it is weakly acidic and less sensitive to humidity.

[Technical Solution]

In order to solve the problems of the related art, the present invention provides an indoor organic photovoltaic (OPV) cell, which includes a transparent electrode formed on a transparent substrate; a hole transport layer formed on the transparent electrode; an active layer formed on an upper surface of the hole transport layer and made of a P3HT:ICBA material; and an upper electrode formed on the upper side of the active layer, wherein the hole transport layer is made of a PSS-doped polyaniline (PANI:PSS) material.

[Advantageous Effects]

According to the present invention, energy can be efficiently collected from indoor lighting.
Also, according to the present invention, a solar cell having improved environmental stability can be manufactured.

[Description of Drawings]

FIG. 1 shows the chemical structures of PANI:PSS, P3HT, and ICBA.
FIG. 2 shows a structure of an OPV cell according to the present invention.
FIG. 3 shows the transmission spectra of ITO, PANI:PSS, and PEDOT:PSS films according to the present invention.
FIG. 4 shows the energy level of each layer of the OPV cell according to the present invention.
FIG. 5 shows the current density (J)/voltage (V) characteristics of the OPV cell according to the present invention under LED lighting.

FIG. 6 is a diagram representing the circuit of a single diode model.

FIG. 7 shows the changes in normalized PCE according to the lifespan of the OPV cell according to the present invention.

[Best Mode]

An indoor photovoltaic (IPV) cell for generating an electromotive force from indoor lighting includes:

a transparent electrode formed on a transparent substrate;
a hole transport layer formed on the transparent electrode;
an active layer formed on the upper surface of the hole transport layer and made of a P3HT:ICBA material; and
an upper electrode formed on the upper side of the active layer,
wherein the hole transport layer is made of a PSS-doped polyaniline (PANI:PSS) material.

[Mode for Invention]

Terms used in this specification will be briefly described, and exemplary embodiments of the present invention will be described in detail. The terms used in this specification have been selected from general terms, which are currently widely used, as much as possible in consideration of the functions in the present invention, but these terms may vary depending on the intention of persons skilled in the art, precedents, the emergence of new technologies, or the like. Also, there are terms optionally selected by the applicant in specific cases, and in this case, the meanings thereof will be described in detail in the description of the present invention. Therefore, the terms used in this specification should be defined based on the meaning of the term and the overall content of the present invention, not simply the name of the term.

Hereinafter, exemplary embodiments of the present invention will be described in detail with reference to the accompanying drawings.

There is an increasing demand for microwatt and self-powered indoor electronic devices such as wireless sensors, wearable devices, smart meters, and actuators. To solve the problem of insufficient power of existing batteries, the development of alternative ambient energy (radio, heat, light, and vibration energy) harvesting technology such as radio frequency converters, thermoelectric generators, vibration energy converters, and research on indoor lighting energy harvesters are under way. Indoor photovoltaic (IPV) cell-based light-collecting technology is one of the convenient methods due to sufficient availability and accessibility of indoor lighting converted into electrical energy. While outdoor PV cells absorb a wider range of wavelengths, IPV cells should exhibit higher absorption in a wavelength range of 300 nm to 1000 nm, which includes the spectrum of indoor artificial lighting such as light-emitting diodes (LEDs), sodium lamps, fluorescent lighting, incandescent lighting, and the like for efficient power conversion. Various types of PV cells such as inorganic, perovskite, organic-inorganic hybrid, dye-sensitized, and organic cells have been tested for indoor use. Among these, it was observed that organic photovoltaic (OPV) cells may exhibit efficient absorption ability and high external quantum efficiency in the above wavelength range.

The HTL plays an important role in OPV cells. Free charge carrier recombination and leakage current may be reduced to improve the hole extraction efficiency of the OPV cells and enhance power conversion efficiency. An ideal hole transport material (HTM) should exhibit higher transmittance, enhanced hole transport ability, environmental and mechanical stability, easier processability, a work function value of approximately 5.2 eV, and inertness to the active layer (AL) and electrode. To date, poly(3,4-ethylene dioxythiophene):poly(4-styrenesulfonic acid) (PEDOT:PSS) is widely used as an HTM for OPV cells due to its high hole mobility, low-temperature processability, water stability, and mechanical stability. However, because PEDOT:PSS is sensitive to strong acids and moisture and is expensive, there are problems in producing inexpensive and stable OPV cells. So far, several alternative materials have been examined as HTMs for outdoor OPV cells, but there is a lack of research on alternative HTM materials that may reduce the production costs of indoor OPV cells and improve the lifespan of the device.

Polyaniline (PANI) is a conventional inexpensive conjugated polymer, and may be used as an HTM for OPV cells for indoor applications because it has environmental stability, high transmittance, adjustable hole transport ability, and low acidity. However, challenges remain to improve processability, conductivity, and water stability.

In the present invention, PSS-doped PANI is synthesized (PANI:PSS), and such a synthesized material is used as an HTL for poly(3-hexylthiophene):[6,6]-indene-C60 bisadduct (P3HT:ICBA)-based OPV cells.

That is, the OPV cell according to the present invention includes a transparent electrode formed on a transparent substrate; a hole transport layer formed on the transparent electrode and made of a conductive organic polymer material; an active layer formed on the upper surface of the hole transport layer and made of a P3HT:ICBA material; and an upper electrode formed on the upper side of the active layer, wherein the hole transport layer is made of a polyaniline material doped with PSS (PANI:PSS).

To examine the usability of PANI:PSS, the transmittance, work function, and conductivity of the PANI:PSS film, and the pH value of the material were measured. Thereafter, the manufactured OPV device was tested by irradiating it with white LED light at a luminance of 500 Lux and 1,000 Lux. For the purpose of comparison, PEDOT:PSS HTL and P3HT:ICBA active material-based OPV devices were also manufactured and tested.

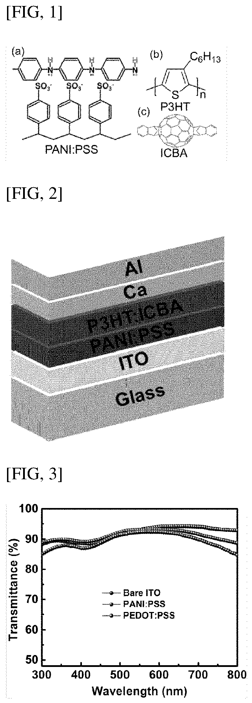

PSS-doped PANI (see FIG. 1A) was synthesized according to a conventional protocol. Briefly, aniline (AN) was purified by vacuum distillation, and 0.40 g of purified aniline was dissolved in 40 mL of ultrapure deionized (DI) water (approximately 18 MS2; an RO 15 reverse osmosis system). The mixture was stirred at 1,000 rpm for an hour at 0 to 5°C, 0.4 g of PSS was added to the solution, and the mixture was stirred for 4 hours.

Next, 4.30 mM ammonium peroxodisulfate (APS) was dissolved in 20mL of DI water, and the resulting solution was stored at 0 to 5°C for 4 hours. Thereafter, the APS solution was slowly mixed with the AN-PSS solution, and the mixture was stirred at 1,000 rpm for 24 hours at 0 to 5°C. The resulting dark green PSS-doped PANI was centrifuged, washed several times with anhydrous ethanol, and resuspended in DI water.

The active material of the OPV cell was dissolved in 1 mL of 1,2-dichlorobenzene by stirring 20 mg of P3HT (see (b) of FIG. 1) and 20 mg of ICBA (see (c) of FIG. 1) at 70°C for 6 hours in a nitrogen-filled glove box (GB).

The OPV device (see FIG. 2) was manufactured on an indium tin oxide (ITO)-coated glass substrate (OMNI.0782). The sheet resistance and thickness of the ITO layer were approximately 10 S2/sq and 200 nm, respectively. The ITO-coated glass substrate was cleaned with a phosphate-free liquid detergent. The substrate was sonicated during washing. Also, the substrate was washed by sonication in deionized water, acetone, and 2-propanol.

The substrate was dried under nitrogen gas and treated with oxygen plasma for 10 minutes. Thereafter, the substrate was transferred to a nitrogen gas-filled GB, and then PANI:PSS (filtered through a 0.45 $\mu$m polyvinylidene difluoride (PVDF) membrane) was spin-coated (at 3,000 rpm for 40 seconds) on the substrate, and annealed at 100 °C for 15 minutes.

Also, the P3HT:ICBA solution was filtered through a polytetrafluoroethylene filter (0.2 $\mu$m), and spin-coated (at 800 rpm for 30 seconds) on the PANI:PSS-coated substrate. The P3HT:ICBA film (approximately 180 nm) was transferred to a preheated hotplate and annealed at 150 °C for 10 minutes in a GB. Thin calcium (approximately 25 nm) and aluminum (approximately 150 nm) layers were deposited on an active layer at a deposition rate of 0.1 to 0.2 nm/s in vacuum (approximately 6 $\mu$Pa) using a thermal evaporation system.

Here, an intermediate layer (Ca) was introduced between a negative electrode (Al) and the active layer of the PV cell to build a bridge between the negative electrode and the active layer. Because Ca has a low work function value, it may be selected as the negative electrode intermediate layer to increase the electrostatic potential difference of the PV device. Also, the intermediate layer may significantly improve device performance by minimizing the contact resistance and maximizing an open circuit voltage (VOC) of the device.

For the purpose of comparison, a PEDOT:PSS HTL-based OPV device was also manufactured. Here, other components of the device and a method of manufacturing the same were identical to those of the PANI:PSS HTL-based OPV device.

The work function values of the ITO layer and the PANI:PSS film were measured by a Kelvin probe. The transmittances of the ITO layer and the PANI:PSS film were monitored using a UV-Vis spectrophotometer at a wavelength of 300 nm to 800 nm. The thickness and active region of other layers of the OPV cell were measured using an Alpha-Step profilometer and an optical microscope, respectively. Data of the current density versus voltage (J/V) characteristics of the OPV cell were recorded using a programmed source meter. The OPV cell was tested under Xe55 AM 1.5G solar simulator light using an LED lamp at 170 $\mu$W/cm$^2$ (500 Lux) or 280 $\mu$W/cm$^2$ (1,000 Lux).

[Table 1]

| Sample | Average transmittance (%) | Work function (eV) | pH | Conductivity (S/cm) |
|---|---|---|---|---|
| ITO | 91.4 | 4.75 | - | - |
| PANI:PSS | 90.9 | 5.15 | 2.2 | $9.14 \times 10^{-4}$ |
| PEDOT:PSS | 88.7 | 5.2 | 1.6 | $1.11 \times 10^{-3}$ |

Table 1 lists the results of measuring the average transmittance, work function, pH, and conductivity of each of the films (ITO, PANI:PSS, and PEDOT:PSS). The pH value of PANI:PSS was 2.2, which was greater than that of PEDOT:PSS (approximately 1.6). That is, PANI:PSS exhibits lower acidity than PEDOT:PSS, which is conventionally used as an HTM.

The work function value of the PANI:PSS film is approximately 5.15 eV, which appears to be suitable for use as an HTL in the OPV cells. Because the HTL of PV cells required a high transmittance value, the transmittance value of the PANI:PSS film was measured in an operating wavelength range (300 to 800 nm).

FIG. 3 shows the transmittance values of a PANI:PSS film and an ITO-coated glass substrate. In particular, the PANI:PSS film exhibits a very high transmittance value ($T_{Average}$ = 90.9 %) (see Table 1), which is comparable to that of existing PEDOT:PSS ($T_{Average}$ = 88.7 %).

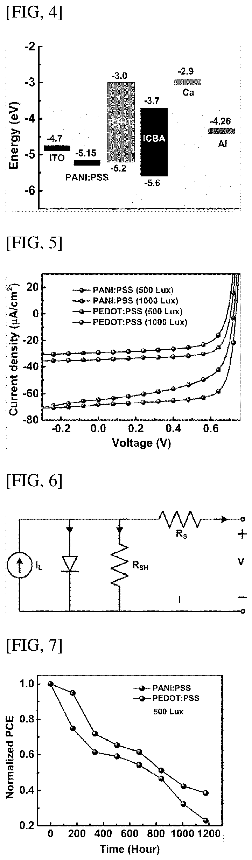

FIG. 4 is a graph showing the energy level of each layer of an OPV cell.

The highest occupied molecular orbital (HOMO) level of a PANI:PSS HTL is approximately 5.15 eV, which is similar to the HOMO level of the OPV cell donor material (P3HT). Therefore, holes may easily move from the active layer to the electrode through the HTL.

To evaluate the applicability of the HTM-based OPV cell in indoor applications, white LED lighting was used at a luminance of 500 Lux and 1,000 Lux. FIG. 5 shows the current density (J)/voltage (V) characteristic curve of the OPV cell operating during lighting. Performance parameters of six devices are shown along with the standard deviation error values averaged over the respective devices in Table 2.

[Table 2]

| HTL | Luminance (Lux) | $P_{in}$ ($\mu W/cm^2$) | $V_{OC}$ (mV) | Jcs ($\mu A/cm^2$) | FF (%) | PCE (%) | $R_{SH} \times A$ ($\Omega \times cm^2$) | MPD ($\mu W/cm^2$) |
|---|---|---|---|---|---|---|---|---|
| PANLPSS | 500 | 170 | 680 ± 2 | 28.4 ± 1.1 | 63.3 ± 0.5 | 7.3 ± 0.4 | $1.6 \times 10^5$ ± $5.8 \times 10^3$ | 12.4 ± 0.6 |
| | 1,000 | 280 | 723 ± 1 | 63.0 ± 2.1 | 61.5 ± 1.7 | 10.0 ± 0.0 | $6.4 \times 10^4$ ± $9.6 \times 10^3$ | 28.0 ± 0.1 |
| PEDOT:PSS | 500 | 170 | 700 ± 6 | 38.2 ± 2.4 | 65.4 ± 8.4 | 10.3 ± 1.6 | $9.9 \times 10^4$ ± $6.1 \times 10^4$ | 17.1 ± 2.9 |
| | 1,000 | 280 | 708 ± 3 | 73.8 ± 8.9 | 69.7 ± 2.9 | 13.0 ± 2.2 | $1.1 \times 10^5$ ± $3.3 \times 10^2$ | 36.5 ± 6.1 |

The power conversion efficiency (PCE) of the PV cell may be estimated as in Equation 1 below.

[Equation 1]

$$PCE = \frac{MPD}{P_{in}} \times 100 = \frac{V_{OC} \times J_{SC} \times FF}{P_{in}}$$

wherein MPD, $P_{in}$, Voc, Jcs, and FF represent the maximum generated power, the irradiance power intensity of incident light, an open circuit voltage, a short circuit current density, and a fill factor, respectively.

The PCE values of the PANI:PSS and PEDOT:PSS HTL-based devices in an indoor environment were calculated using Equation 1 above. As observed, the PANI:PSS HTL-based OPV cell may operate at PCEs of 7.3 ± 0.4% and 10.0 ± 0.0%, respectively, when the OPV cell is illuminated with white LED light at a luminance of 500 Lux and 1000 Lux. On the other hand, the PEDOT:PSS HTL-based OPV cell may operate at PCEs of 10.3 ± 1.6% and 13.0 ± 2.2% under 500 Lux and 1,000 Lux LED light, respectively. Here, the PANI:PSS HTL-based OPV cell had lower PCE values than the PEDOT:PSS HTL-based OPV cell (approximately 30% and approximately 20% lower for 500 Lux and 1000 Lux LEDs, respectively).

This may be due to the PEDOT:PSS layer having lower conductivity than the PEDOT:PSS layer (see Table 1). Shunt resistance ($R_{SH}$) is important in low-irradiance indoor applications because low irradiance lowers light-generated current and has a greater influence on the current loss due to the PV cell's $R_{SH}$. Therefore, the OPV cell with higher $R_{SH}$ is suitable for indoor applications. To estimate the $R_{SH}$ values of the PANI:PSS and PEDOT:PSS HTL-based OPV cells, the device was considered to be a diode, and the standard single diode model was applied (see FIG. 6). According to the single diode model, the current (I) of the PV cell may be induced as in Equation 2 below.

5

[Equation 2]

$$I = I_L - I_S\left[\exp\left(\frac{(qV + IR_S)}{nk_BT}\right) - 1\right] - \frac{(V + IR_S)}{R_{SH}}$$

wherein $I_L$, Is, V, Rs, n, $k_B$, and T represent light-generated current, saturation current, a voltage, serial resistance, a diode identification coefficient, the Boltzmann constant, and a temperature, respectively. The $R_{SH}$ values of the PV cells (see Table 2) were calculated for two different lighting conditions (500 and 1,000 Lux) by analyzing the current/voltage (I/V) characteristics of the device using Equation 2. The PANI:PSS and PEDOT:PSS HTL-based OPV cells exhibited very high $R_{SH}$, thereby reducing the potential for current loss due to the formation of alternative current paths. Due to this phenomenon, the OPV cells exhibited high PCE in indoor environments.

To compare the long-term stability of the PANI:PSS and PEDOT:PSS-based OPV cells, the OPV cells were tested for 1,176 hours. FIG. 7 shows the changes in normalized PCE values of the respective OPV cells according to aging time. In the case of the PANI:PSS HTL-based OPV cell, a decrease to 39% of the initial PCE value was observed. On the other hand, in the case of the PEDOT:PSS-based OPV cell, the PCE value decreased to 23% of the initial value. The PANI:PSS HTL-based OPV cell had a lower PCE than the PEDOT:PSS HTL-based OPV under indoor environments, but exhibited better stability than the existing PEDOT:PSS HTL-based OPV cell. This may be due to PANI:PSS having lower acidity and hygroscopicity than PEDOT:PSS.

As described above, inexpensive, less acidic, and water-stable PSS-doped PANI was used as the HTM of the P3HT:ICBA active material-based OPV cell for indoor applications. Water-stable PANI:PSS may be synthesized using a simple protocol. Films formed of PANI:PSS exhibited a transmittance of 90% or more in an operating wavelength range. Also, the PANI:PSS HTL film exhibited higher work function and conductivity.

The OPV cells thus obtained exhibited high shunt resistance ($R_{SH}$) when illuminated with white light during operation. As a result, this reduced current loss due to the formation of alternative current paths in the device.

Also, the PANI:PSS HTL-based OPV cell exhibited excellent PCE when operated in indoor environments. The OPV cell exhibited approximately 10% PCE (close to conventional PEDOT:PSS HTL-based OPV cells) under 1,000 Lux white LED light.

Further, the PANI:PSS HTL-based indoor OPV cell exhibited better stability than the PEDOT:PSS HTL-based OPV cell due to low acidity and hygroscopicity.

The above-described preferred embodiments of the present invention have been described for illustrative purposes, those skilled in the art will be able to make various modifications, changes, and additions to the present invention within the spirit and scope of the present invention, and the modifications, changes, and additions should be considered as being included in the scope of the appended claims.

Because various substitutions, modifications, and changes can be made by those skilled in the art to which the present invention pertains without departing from the technical spirit of the present invention, the present invention is not limited to the above-described exempalry embodiments and the accompanying drawings.

[Industrial Applicability]

According to the present invention, energy may be efficiently collected from indoor lighting.

Also, according to the present invention, a solar cell having improved environmental stability may be manufactured.

Claims

1. An indoor organic photovoltaic (OPV) cell for generating an electromotive force from indoor lighting, comprising:

    a transparent electrode formed on a transparent substrate;
    a hole transport layer formed on the transparent electrode;
    an active layer formed on a upper surface of the hole transport layer and made of a P3HT:ICBA material; and
    an upper electrode formed on the upper side of the active layer,
    wherein the hole transport layer is made of a PSS-doped polyaniline (PANI:PSS) material.

2. The indoor organic photovoltaic cell of claim 1, further comprising an intermediate layer configured to increase an electrostatic potential difference of the photovoltaic cell,
wherein the intermediate layer is formed between the active layer and the upper electrode, and is formed of a material selected from one of metals having a low work function value including Ca.

3. A method of synthesizing PSS-doped polyaniline used as a hole transport material in an indoor organic photovoltaic (OPV) cell, comprising:

purifying aniline (AN) by vacuum distillation;
dissolving the purified aniline in ultrapure deionized water (DI);
adding PSS to the solution, followed by stirring;
mixing an ammonium peroxodisulfate (APS) solution with the AN-PSS solution, followed by stirring; and
centrifuging the resulting PSS-doped PANI.

[FIG, 1]

[FIG, 2]

[FIG, 3]

[FIG, 4]

[FIG, 5]

[FIG, 6]

[FIG, 7]

# EP 4 322 234 A1

<table>
<tr><th colspan="2">INTERNATIONAL SEARCH REPORT</th><th>International application No.<br><br>**PCT/KR2021/005533**</th></tr>
</table>

**A.   CLASSIFICATION OF SUBJECT MATTER**

**H01L 51/42**(2006.01)i; **H01L 51/44**(2006.01)i; **H01L 51/00**(2006.01)i

According to International Patent Classification (IPC) or to both national classification and IPC

**B.   FIELDS SEARCHED**

Minimum documentation searched (classification system followed by classification symbols)

H01L 51/42(2006.01); H01L 31/0256(2006.01); H01L 31/0725(2012.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유기태양셀(organic solar cell), 실내(indoor), 정공 수송층(HTL, hole transporting layer), 폴리아닐린(polyaniline, PANI), 폴리스티렌술폰산(polystyrene sulfonic acid, PSS), 도핑(doping)

**C.   DOCUMENTS CONSIDERED TO BE RELEVANT**

| Category* | Citation of document, with indication, where appropriate, of the relevant passages | Relevant to claim No. |
|---|---|---|
| X | BISWAS, S. et al. Utilization of poly (4-styrenesulfonic acid) doped polyaniline as a hole transport layer of organic solar cell for indoor applications. Thin solid films. 2020 [electronic publication: 05 March 2020 ], vol. 700, thesis no.: 137921 (inner pp. 1-5).<br>    See abstract; inner page 2; and figure 2. | 1-3 |
| X | BISWAS, S. et al. Efficiency improvement of indoor organic solar cell by optimization of the doping level of the hole extraction layer. Dyes and pigments. 2020 [electronic publication: 01 August 2020], vol. 183, thesis no.: 108719 (inner pp. 1-8).<br>    See abstract; inner pages 2 and 3; and figure 1. | 1-3 |
| X | BISWAS, S. et al. Decent efficiency improvement of organic photovoltaic cell with low acidic hole transport material by controlling doping concentration. Applied surface science. 2020 [electronic publication: 12 February 2020], vol. 512, thesis no.: 145700 (inner pp. 1-8).<br>    See abstract; inner pages 2 and 3; and figure 2. | 1-3 |
| X | ABDELMAGID, A. et al. Effect of different ratios of polyaniline: poly (styrene sulfonate) on the hole extraction ability in perovskite solar cells. Synthetic metals. 2020 [electronic publication: 20 November 2019], vol. 259, thesis no.: 116232 (inner pp. 1-5).<br>    See abstract; and inner page 2. | 3 |

☑ Further documents are listed in the continuation of Box C.        ☑ See patent family annex.

| | | |
|---|---|---|
| * | Special categories of cited documents: | |
| "A" | document defining the general state of the art which is not considered to be of particular relevance | "T"   later document published after the international filing date or priority date and not in conflict with the application but cited to understand the principle or theory underlying the invention |
| "D" | document cited by the applicant in the international application | "X"   document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&"   document member of the same patent family |
| "P" | document published prior to the international filing date but later than the priority date claimed | |

| Date of the actual completion of the international search | Date of mailing of the international search report |
|---|---|
| **12 July 2022** | **12 July 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**

| International application No. |
| --- |
| **PCT/KR2021/005533** |

**C.** **DOCUMENTS CONSIDERED TO BE RELEVANT**

| Category* | Citation of document, with indication, where appropriate, of the relevant passages | Relevant to claim No. |
| --- | --- | --- |
| X | BISWAS, S. et al. Improved charge transport in PANI: PSS by the uniform dispersion of silver nanoparticles. Applied surface science. 2019, vol. 483, pp. 819-826. <br> See abstract; and page 820. | 3 |
| A | KR 10-2014-0029409 A (THE REGENTS OF THE UNIVERSITY OF CALIFORNIA) 10 March 2014 (2014-03-10) <br> See claims 1-39; and paragraphs [0045] and [0046]. | 1-3 |
| A | KR 10-2015-0038353 A (THE REGENTS OF THE UNIVERSITY OF MICHIGAN) 08 April 2015 (2015-04-08) <br> See claims 1-22. | 1-3 |

Form PCT/ISA/210 (second sheet) (July 2019)

**INTERNATIONAL SEARCH REPORT**
Information on patent family members

International application No.

**PCT/KR2021/005533**

| Patent document cited in search report | | | Publication date (day/month/year) | Patent family member(s) | | | Publication date (day/month/year) |
|---|---|---|---|---|---|---|---|
| KR | 10-2014-0029409 | A | 10 March 2014 | AU | 2012-236408 | A1 | 17 October 2013 |
| | | | | BR | 112013024418 | A2 | 20 December 2016 |
| | | | | CA | 2831394 | A1 | 04 October 2012 |
| | | | | CN | 103597601 | A | 19 February 2014 |
| | | | | CN | 103597601 | B | 21 September 2016 |
| | | | | EP | 2691993 | A2 | 05 February 2014 |
| | | | | JP | 2014-512100 | A | 19 May 2014 |
| | | | | MX | 2013011261 | A | 27 March 2014 |
| | | | | RU | 2013147989 | A | 10 May 2015 |
| | | | | SG | 193951 | A1 | 29 November 2013 |
| | | | | US | 10026899 | B2 | 17 July 2018 |
| | | | | US | 2014-0020739 | A1 | 23 January 2014 |
| | | | | US | 2017-0062723 | A1 | 02 March 2017 |
| | | | | US | 9425420 | B2 | 23 August 2016 |
| | | | | WO | 2012-135527 | A2 | 04 October 2012 |
| | | | | WO | 2012-135527 | A3 | 28 March 2013 |
| | | | | ZA | 201307261 | B | 23 December 2014 |
| KR | 10-2015-0038353 | A | 08 April 2015 | AU | 2013-296423 | A1 | 19 February 2015 |
| | | | | AU | 2013-296423 | A1 | 06 February 2014 |
| | | | | CA | 2880519 | A1 | 06 February 2014 |
| | | | | CN | 104854720 | A | 19 August 2015 |
| | | | | EP | 2880697 | A1 | 10 June 2015 |
| | | | | IN | 1247DEN2015 | A | 26 June 2015 |
| | | | | JP | 2015-523741 | A | 13 August 2015 |
| | | | | TW | 201411910 | A | 16 March 2014 |
| | | | | US | 10297775 | B2 | 21 May 2019 |
| | | | | US | 2015-0207090 | A1 | 23 July 2015 |
| | | | | WO | 2014-022580 | A1 | 06 February 2014 |
| | | | | WO | 2014-022580 | A8 | 02 April 2014 |

Form PCT/ISA/210 (patent family annex) (July 2019)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MATHEWS et al.** Technology and market: perspective for indoor photovoltaic cells. *Joule,* 2019, vol. 3, 1415-1426

- **ABDULRAZZAQ et al.** Comparative aging study of organic solar cells utilizing polyaniline and PEDOT: PSS as hole transport layers. *ACS Appl. Mater. Interfaces,* 2015, vol. 7, 27667-27675